# EUROPEAN PATENT SPECIFICATION

(11) **EP 1 897 986 B1**
(45) Date of publication and mention of the grant of the patent: **23.06.2010**
(21) Application number: 06120092.9
(22) Date of filing: 05.09.2006
(51) Int. Cl.: D06F 35/00, B08B 7/00, D06B 19/00

(54) **Fabric cleaning apparatus**
Gewebereinigungsvorrichtung
Appareil de nettoyage de tissu

(43) Date of publication of application: 12.03.2008
(73) Proprietor: Electrolux Home Products Corporation N.V., 1930 Zaventem (BE)
(72) Inventor: Fabbro, Edi, 33032 Bertiolo (Udine) (IT); Alexandrov, Sergei, 195251, St.- Petersburg (RU)
(74) Representative: Baumgartl, Gerhard Willi

(56) References cited:
- DE-A1- 4 432 919
- DE-A1- 19 842 095
- JP-A- 2005 087 540
- JP-A- 2005 087 541
- JP-A- 2005 103 376
- JP-A- 2005 224 757

## Description

The present invention refers to a fabric cleaning apparatus.

The use of plasma to remove stains of organic substances from fabrics is known from the disclosures in JP2005087540, JP2005087541 and JP2005224757.

In particular, JP2005224757 discloses a plasma cleaning device intended for application to a hand iron. The plasma cleaning device is provided with an inlet to take in steam jetting out from the bottom surface of the hot plate, i.e. the flat base of the smoothing iron, a pair of metal electrodes producing plasma at atmospheric pressure, and an outlet discharging chemically very reactive molecules and atoms that are generated in the plasma.

The steam taken in through the inlet is introduced across the pair of metal electrodes of the parallel-plate type forming a dielectric-barrier discharge assembly, which are connected to a high-voltage AC generator for a discharge current to be produced across the pair of metal electrodes by having a predetermined electric field impressed, i.e. applied thereupon.

Dielectric-barrier discharge assemblies are characterized by the presence of one or more dielectric layers in the current path between a pair of metal electrodes provided in a mutually facing arrangement so to form a gap therebetween, in which an aeriform or gaseous medium, such as for instance air and/or steam, is present as it flows therethrough.

When an AC voltage is applied to such electrode arrangement with one or both electrodes covered by a dielectric layer, a dielectric barrier discharge (DBD) appears in the gas gap between the two electrodes.

A DBD consists of a number of self pulsing micro-discharges in the gas gap (or discharge gap), with corresponding surface discharges on the dielectric. The time constant of these processes lies in the nanosecond region. The electric energy coupled into the gas is mainly used to produce energetic electrons, while the gas remains at nearly ambient temperature.

Due to them colliding with the energetic electrons, the molecules in the steam that flow between the parallel-plate type electrodes are ionized, dissociated and excited, thereby generating active species, i.e. extremely reactive particles chemically, e.g. OH⁻, H⁺, O atomic, O₃, N atomic. The thus generated active species are discharged from the outlet onto the stained fabrics to be cleaned.

These active species either react with the organic substances of the stain chemically, thereby forming volatile compounds that are released from and leave the fabric, or act by oxidizing the organic substances of the stain so that they can then be simply brushed off. In practice, these active species attack the organic material of the stain chemically, so that the latter is disgregated and removed without any assisting liquid solvent being required in the process.

The plasma cleaning device disclosed in JP2005224757 has a number of drawbacks.

In the first place, the device is scarcely convenient in use, since - to have it operating - it is necessary for the flat iron base to be applied onto an upper portion of the device, where the inlet to the discharge gap is provided, so as to supply the latter with the steam produced by the hand iron.

Another drawback arises from the fact that it practically proves quite awkward for the outlet from the discharge gap to be appropriately positioned in proximity of the organic substances forming the spot staining the fabric to be cleaned. It can be most readily appreciated that the closest the outlet from the discharge gap is positioned to the stain to be removed, the greater the effectiveness of the plasma will be in removing the same stain. In the case that the outlet from the discharge gap is positioned relatively far from the stain to be removed, the effects of the plasma issuing from the discharge gap recombining with the surrounding air would cause the proportional amount of active species reaching the fabric to decrease to a considerable extent, thereby sensibly reducing the stain removal effect.

The user, who is forced to operate the device with the aid of the handle of the flatiron, is therefore not capable of correctly positioning the outlet from the discharge gap in proximity of the stain to be treated, since the flatiron and the outer structure of the same plasma cleaning device act as a hindrance in this connection by at least partially concealing both the outlet from the discharge gap, which is provided on the lower portion of the plasma cleaning device, and the fabric lying thereunder.

A further drawback of the device disclosed in JP2005224757 lies in the fact that the electrodes forming the discharge gap are not electrically insulated to any adequate extent and, when the flatiron is applied on to the plasma cleaning device, the metal hotplate of the flatiron comes to lie dangerously close to the electrodes at the risk of giving rise to arcing and flashover occurrences on the same hotplate.

Yet another drawback of the device disclosed in JP2005224757 derives from the fact that supplying the discharge gap with the steam generated by the flatiron proves scarcely effective and - moreover - rather complicated. In fact, for the steam to be enabled to reach the discharge gap, a kind of chamber is provided between the portion of hotplate which the steam is issuing from and an upper portion of the plasma cleaning device, where there is provided the inlet to the discharge gap. Such solution, however, does not ensure any adequate flow of steam through the discharge gap, with the result of a low generation of plasma and, as a consequence, a low generation rate of active species. For a high generation rate of active species to be ensured, it is in fact important to have a consistent flow of aeriform or gaseous medium flowing through the discharge gap.

A further drawback yet of the above-cited prior art derives from the fact that, as the plasma cleaning device is being used, the high-voltage AC generator is due to stay constantly in an energized state, unless the power-supply plug is disconnected from the power-supply line. For instance, the high-voltage AC generator would in fact remain in an energized state throughout the period of time required for the user to succeed in identifying the exact position of each single stain on the fabric to be cleaned and moving the outlet of the discharge gap from a stain to the next one. It can be readily appreciated that, during these time intervals when the device is not really used to do its actual job, this leads to energy being wasted and ozone being generated to no effective avail.

It is therefore a main object of the present invention to provide a fabric cleaning apparatus, which is effective in doing away with the above-noted drawbacks of the cited prior art.

Within this general object, it is a further purpose of the present invention to provide a fabric cleaning apparatus of the above-mentioned kind, which is most effective in removing organic-soil stains from the fabrics, is simple to manufacture and convenient to use.

According to the present invention, these aims, along with further ones that will become apparent from the following disclosure, are reached in a fabric cleaning apparatus that incorporates the features as defined and recited in the claims appended hereto.

Features and advantages of the present invention will anyway be more readily understood from the description that is given below by way of nonlimiting example with reference to the accompanying drawings, in which:

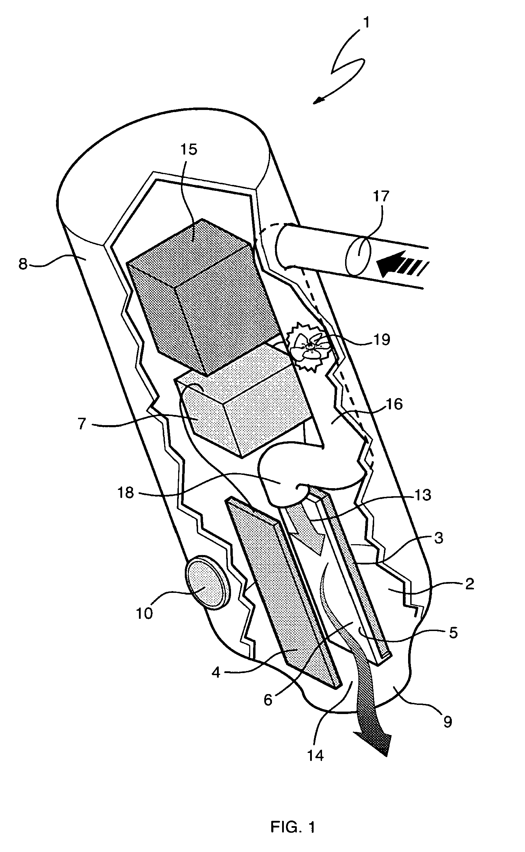

- Figure 1 is a perspective view of a fabric cleaning apparatus according to the present invention, as viewed with the casing thereof shown in a partially cut-away representation;

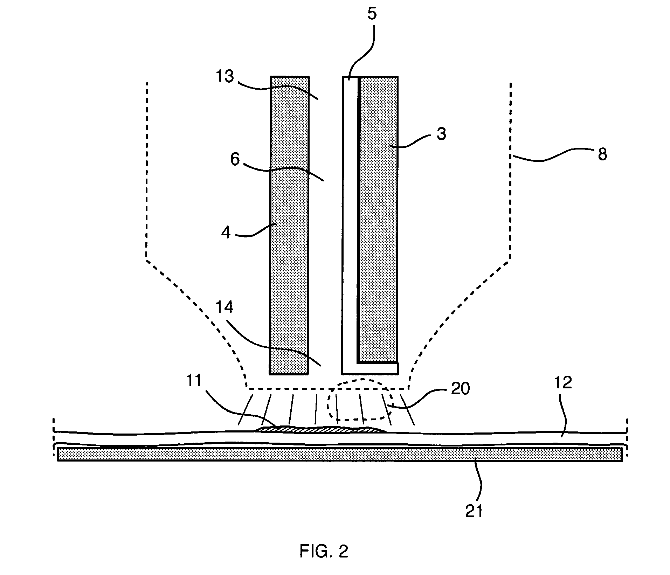

- Figure 2 is an enlarged side view of the discharge gap of the fabric cleaning apparatus shown in Figure 1, wherein the casing of the apparatus is shown in a see-through representation;
- Figure 3 is a perspective view of a fabric cleaning apparatus according to another embodiment of the present invention, as viewed with the casing thereof shown in a partially cut-away representation;
- Figure 4 is a perspective view of a fabric cleaning apparatus according to a further embodiment of the present invention, as viewed with the casing thereof shown in a partially cut-away representation;
- Figure 5 is a side elevational cross-sectional view of the apparatus shown in Figure 4;
- Figure 6 is a front elevational cross-sectional view of the apparatus shown in Figure 4.

With reference to the above-cited Figures, the fabric cleaning apparatus, as generally indicated with the reference numeral 1, comprises at least a dielectric-barrier discharge assembly 2 adapted to generate plasma at atmospheric pressure for decomposing and removing organic-soil stains from the fabrics to be cleaned.

The dielectric-barrier discharge assembly includes a high-voltage electrode 3, a counter-electrode 4, and at least a dielectric barrier 5 defining a discharge gap 6 between said electrodes 3, 4.

The apparatus 1 comprises a high-voltage AC generator 7 connected to said high-voltage electrode 3, as well as fluid supplying means provided to supply the discharge gap 6 with a flow of aeriform medium.

The apparatus 1 further comprises an electrically insulating outer casing 8 accommodating said dielectric-barrier discharge assembly 2 and provided with an outlet nozzle 9 that is fluidly connected with said discharge gap 6, said casing 8 being adapted to be seized and held by a user so as to enable the latter to position said outlet nozzle 9 close possible to a stained portion of the fabric to be cleaned; switching means 10 are provided on said outer casing 8 to switch on and off said high-voltage AC generator 7 and actuate said fluid supplying means.

The outer casing 8 is comprised of a containment body that is so shaped as to be able to be seized and held with a single hand by a user, who is in this way capable of directing in a localized manner the flow of plasma issuing from the outlet nozzle 9 onto an organic-soil stain 11 that needs to be removed from a fabric 12. In this connection, the outer casing 8 is preferably comprised of an elongated hollow body that extends in a longitudinal direction and defines, at an end portion thereof, a possibly tapered outlet port forming the outlet nozzle 9 provided to direct the plasma onto the stained fabric.

The high-voltage electrode 3 and the counter-electrode 4 are provided in a mutually facing arrangement duly spaced from each other, whereas the dielectric barrier 5, in the particular embodiment being discussed, comprises a coating layer that covers the surface of the high-voltage electrode 3 facing the counter-electrode 4, so as to provide, between the electrodes, the discharge gap 6 where the plasma is generated. In practice, the discharge gap 6 defines a fluid passage comprising an inlet section 13, which is fluidly connected with the fluid supplying means to receive the aeriform medium, and an outlet section 14, which is arranged in proximity of the outlet nozzle 9 of the outer casing 8, from which the plasma being generated along the discharge gap 6 issues to be directed at hitting an organic-soil stain 11 that needs being removed from a fabric 12, such as a garment or clothing item to be cleaned.

The high-voltage AC generator 7, which is connected to the high-voltage electrode 3, is accommodated inside the casing 8.

Advantageously, the counter-electrode 4 is connected to ground.

In a preferred manner, the high-voltage AC generator 7 is connected to a power supply 15, which is also arranged within the casing 8.

The power supply 15 preferably comprises a storage battery, such as in particular a rechargeable storage battery, provided to supply the generator in an autonomous manner.

Alternatively, the high-voltage AC generator 7 may be supplied from the power-supply line or a low-voltage power-supply source.

The fluid supplying means comprise a fluid-carrying conduit 16, which is provided inside the casing 8 to convey an air stream flowing in from the ambient surrounding the hand-held outer casing 8 of the apparatus towards the inlet section 13. This fluid-carrying conduit 16 may even be provided integrally in a properly shaped and conformed inner portion of the casing 8.

The fluid-carrying conduit 16 includes an inlet port 17 that is fluidly connected with the outside ambient surrounding the outer casing 8, as well as an outlet port 18 that is fluidly connected with the inlet section 13 of the discharge gap 6.

In addition, the fluid supplying means comprise at least a fan or impeller 19, which is arranged inside the outer casing 8 so as to be adapted to force an air stream through the fluid-carrying conduit 16.

In particular, the fan 19 is adapted to take in air from the outside ambient surrounding the casing 8 through the inlet port 17 of the fluid-carrying conduit 16, and to convey this air towards the outlet port 18 of the same fluid-carrying conduit 16, from which it is then blown into the inlet section 13 of the discharge gap 6.

Also the motor means used to drive the fan are arranged within the casing 8 and are preferably energized from the rechargeable storage battery.

In particular, the fan 19 is arranged along the fluid-carrying conduit 16, inside the same, between the inlet port 17 and the outlet port 18 thereof.

The switching means 10 comprise a push-button, which is actuatably provided on the outer casing 8 to control circuit means connected to the power supply 15 in view of energizing/de-energizing the high-voltage electrode 3 and switching on/off the fan 19 as desired by the user.

Advantageously, the switching means 10 are such as to enable the high-voltage electrode 3 to be energized and the fan 19 to be switched on at the same time and, conversely, the high-voltage electrode 3 to be deenergized and the fan 19 to be switched off at the same time, in such a manner as to minimize the energy usage of the apparatus 1, as well as to limit plasma generation to the sole period of time as strictly necessary for the stain to be removed.

In practice, when the need arises for a user to remove an organic-soil stain from a clothing item, or the like, it just takes for the outlet nozzle 9 of the outer casing 8 to be brought as close as possible to the stain 11 and the push-button of the switching means 10 to be pressed down.

The fan 19, as switched on by said push-button being so actuated, forces a continuous air stream to flow into and through the discharge gap 6, where the electric field produced by the high-voltage electrode 3 - which is in turn energized through the switching means 10 - brings about a sequence of micro-discharges across the dielectric barrier 5, which cause the air stream flowing through the discharge gap 6 to ionize, thereby generating highly reactive molecular or atomic particles, which chemically bind to the organic matters in the stain to thereby form volatile compounds or oxidize such organic matters. When the stain is eventually removed or oxidized, all it takes is to press again the above-cited push-button to de-energize the high-voltage electrode and - at the same time - switch off the fan.

The possibility is therefore given for each single stain to be treated selectively and individually, thereby limiting the energy usage and the generation of the highly reactive particles to such amount and period of time as strictly necessary for a stain to be removed.

In a particularly preferred embodiment, the dielectric barrier 5 is arranged to cover a surface of the high-voltage electrode 3 that is provided at the outlet section 14 of the discharge gap 6 and faces the outlet nozzle 9 of the outer casing 8, so as to form an auxiliary discharge gap 20 with an auxiliary ground electrode 21 provided outside the casing 8 and adapted to support the stained fabric in proximity of the outlet nozzle 9.

In practice, the auxiliary discharge gap 20 is created through the use of an auxiliary ground electrode 21, which may consist of either any metal surface that is readily available to the user or a metal surface that is specially provided jointly with the fabric cleaning apparatus according to the present invention. The stained portion of the fabric that needs being treated to cleaning purposes is then placed on such auxiliary ground electrode 21.

The auxiliary discharge gap 20 is formed by appropriately approaching the outlet nozzle 9 of the outer casing 8 close to the stain 11 on the fabric 12, so as to bring the surface of the high-voltage electrode 3, which is facing the outlet nozzle 9 of the casing 8, and which is covered by the dielectric barrier 5, as close as possible to the auxiliary ground electrode 21 supporting the stained fabric that lies therebelow.

When the high-voltage electrode 3 is then energized, micro-discharges are produced even in the portion of the dielectric barrier 5 that is facing the auxiliary ground electrode 21, as well as within the auxiliary discharge gap 20.

Together with the discharge gap 6, the auxiliary discharge gap 20 allows a generation rate of highly reactive particles to be obtained, which is clearly higher than the generation rate that is usually obtained with the use of the discharge gap 6 alone. As a result, a greater amount of highly reactive particles are therefore made available on the surface of the stained fabric to chemically react with the organic substances forming the stain to be removed, thereby enhancing the effectiveness of the cleaning process.

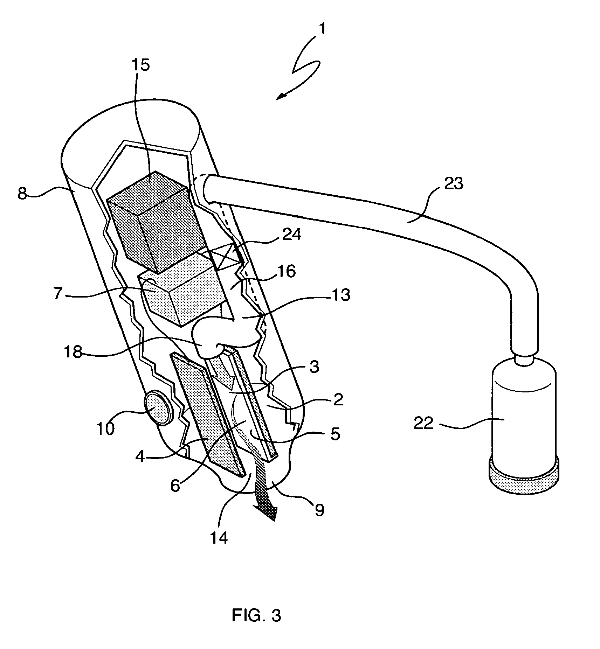

In a further embodiment of the present invention, as illustrated in Figure 3, the fluid supplying means comprise a reservoir 22 containing a compressed medium, which is connected to the fluid-carrying conduit 16 to supply the discharge gap 6 with a continuous flow of aeriform medium. In an advantageous manner, an additional conduit 23, preferably a flexible tube, is provided to fluidly connect the reservoir 22 with the fluid-carrying conduit 16 at the inlet port 17.

This additional conduit 23 may of course be provided in a single-piece, unitary construction with the fluid-carrying conduit 16. In particular, the additional conduit 23 may be formed by an extension of the fluid-carrying conduit 16 starting from the inlet port 17.

The reservoir 22, e.g. a gas bottle or a gas cylinder, advantageously contains a mixture of compressed media (possibly including air and water vapour) or highly volatile substances, which, when ionized, dissociated and excited within the discharge gap 6, produce and deliver extremely reactive particles adapted to either combine with the organic substances staining the fabric to form volatile compounds therewith, or to oxidize such organic substances.

It has been experimentally found that, among various media investigated, the substances that most of all seem to suit this application include alcohols (R-OH), which deliver OH⁻ groups; formic acid (HCOOH) or formaldehyde (HCOH), which deliver OH⁻, H⁺, O atomic; freons, which deliver Cl⁻, F-, Br-; ammonia (NH₃) and hydrazine (N₂H₄), which deliver amino groups. Advantageously, use can be made of bottles or cylinders, which may contain different mixtures of compressed media, or even a single specific compressed aeriform substance, depending on the type of organic soil to be removed from the fabric.

The fluid supplying means further comprise valve means 24 provided to control and adjust the flow of the gaseous stream passing through the outlet port 18 of the fluid-carrying conduit 16 and, therefore, to adjust the flow that passes through the discharge gap 6.

These valve means 24 are in fact adapted to establish a fluid communication, or cut off said fluid communication, as the case may be, between the reservoir 22 containing the pressurized fluid mixture and the outlet port 18 of the fluid-carrying conduit 16.

The switching means 10, which - as already mentioned afore - are provided to be actuatable by the user on the outer casing 8 of the apparatus, are adapted to switch the valve means 24 on and off, i.e. into opening and closing, as needed.

In particular, with the same switching means it is possible for the high-voltage electrode 3 to be energized and, at the same time, the valve means 24 to be switched into opening, in the same manner as already described hereinbefore for the fan 19.

Preferably, the valve means 24 are housed in the casing 8 and, in an advantageous manner, are provided inside the fluid-carrying conduit 16.

The above-mentioned valve means may for instance be comprised of an electromagnetic valve powered from the power supply 15 and connected to the switching means 10.

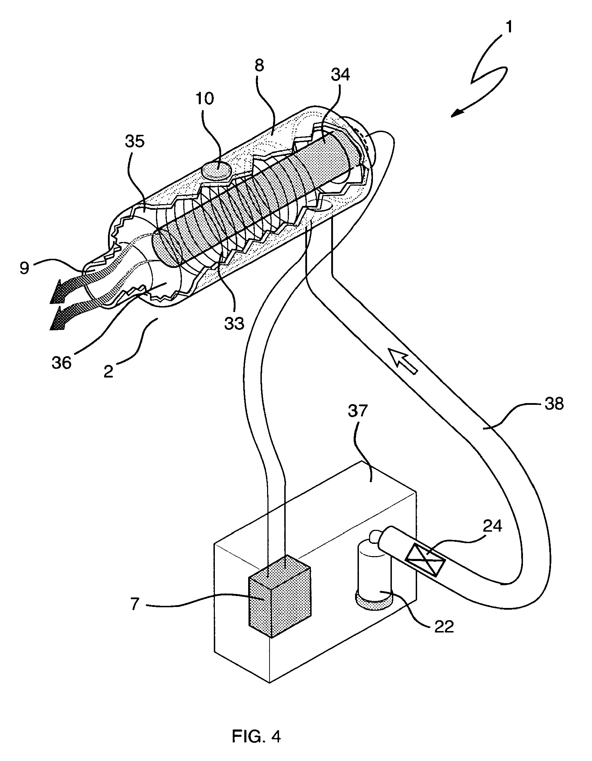

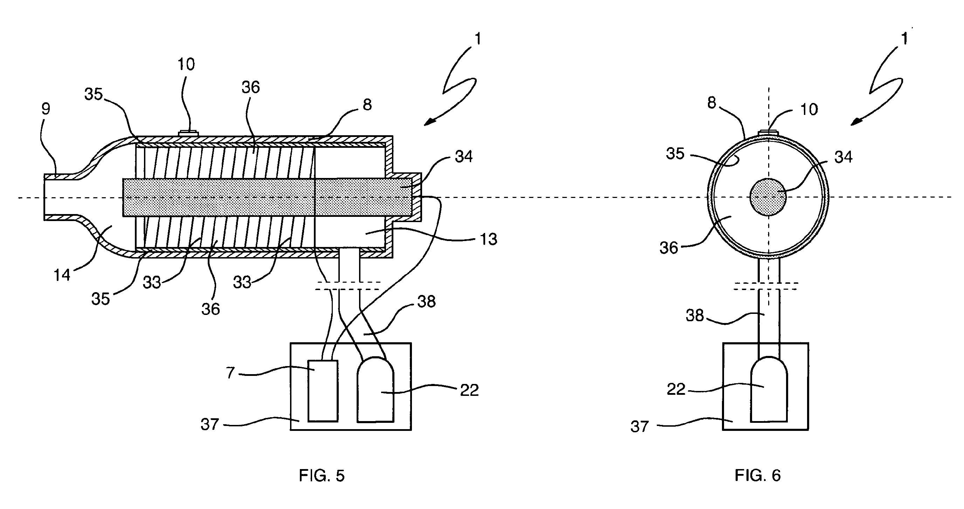

In a yet further embodiment of the present invention, as illustrated in the Figures 4-6, the dielectric-barrier discharge assembly 2 comprises a dielectric barrier 35 that surrounds, i.e. encloses a counter-electrode 34 without contacting it, wherein said counter-electrode 34 is arranged within the dielectric barrier 35, and comprises a high-voltage electrode 33 in the form of a wire that is spirally wound on the outside of the dielectric barrier 35, in contact thereto.

Between the counter-electrode 34 and the dielectric barrier 35 there is therefore formed a discharge gap 36, which is adapted to be supplied with a flow of aeriform medium by the fluid supplying means.

In the exemplary embodiment being described, the dielectric barrier 35 comprises a hollow cylinder of a dielectric material, preferably of glass, in the interior of which there is coaxially provided the counter-electrode 34, which is in turn formed of a rod-like body extending along the axis of the cylinder of the dielectric element 35 and is connected to ground. The high-voltage electrode 33 comprises an electrically conductive wire that is spirally wound round the outer surface of the cylinder forming the dielectric barrier 35. The annular gap comprised between the dielectric barrier 35 and the counter-electrode 34 forms the discharge gap 36, through which there flows the aeriform medium undergoing ionization.

Owing to its having a number of sharp or markedly curved points with a very high potential gradient, the wire-wound high-voltage electrode 33 is effective in favouring the formation of micro-discharges across the dielectric barrier as compared with a low-curvature or flat electrode, such as a plate, thereby enhancing plasma generation.

In practice, the discharge gap 36 defines a passage for a medium flow comprising an inlet section 13, which is fluidly connected with the fluid supplying means to receive the aeriform medium, and an outlet section 14, which is arranged in proximity of the outlet nozzle 9 of the outer casing 8, from which the plasma being generated along the discharge gap 36 issues to be directed at hitting an organic-soil stain 11 that needs being removed from a fabric 12, such as a garment or clothing item to be cleaned.

The electrically insulating outer casing 8 surrounds and contains the dielectric-barrier discharge assembly 2, whereas the high-voltage AC generator 7 and the fluid supplying means are provided outside the casing in a proper separate station 37.
As a result, both the dielectric-barrier discharge assembly 2 and the electrically insulating outer casing 8 can be given an extremely compact size, just like a pen or the like.

The separate station 37 accommodates the high-voltage AC generator 7, which is connected - via appropriate electric cables - to the high-voltage electrode 33. The high-voltage AC generator 7 may be supplied directly from the power-supply line, a low-voltage power-supply source, or a power supply 15 specially provided inside the station 37, preferably in the form of a storage battery, in particular a rechargeable storage battery.

The fluid supplying means comprise a reservoir 22, which is arranged inside the station 37 to contain a compressed medium, and is fluidly connected to the discharge gap 36.

A delivery conduit 38, preferably a flexible tube, is provided between the station 37 and the outer casing 8 to fluidly connect the reservoir 22 to the inlet section 13 of the discharge gap 36.

Advantageously, the reservoir, which may for example be a gas bottle or gas cylinder, contains mixture of compressed media (possibly including air and water vapour) or highly volatile substances, which, when ionized, dissociated and excited within the discharge gap 36, produce and deliver extremely reactive particles adapted to either combine with the organic substances staining the fabric so as to form volatile compounds therewith, or to oxidize such organic substances.

It has been experimentally found that, among various media investigated, the substances that most of all seem to suit this application include alcohols (R-OH), which deliver OH⁻ groups; formic acid (HCOOH) or formaldehyde (HCOH), which deliver OH⁻, H⁺, O atomic; freons, which deliver Cl⁻, F⁻, Br⁻; ammonia (NH₃) and hydrazine (N₂H₄), which deliver amino groups. Advantageously, use can be made of bottles or cylinders, which may contain different mixtures of compressed media, or even a single specific compressed aeriform substance, depending on the type of organic soil to be removed from the fabric.

The fluid supplying means further comprise valve means 24 provided to control and adjust the flow of the gaseous stream passing through the delivery conduit 38 and, therefore, to adjust the flow that passes through the discharge gap 36.

These valve means 24 are in fact adapted to establish a fluid communication, or cut off said fluid communication, as the case may be, between the reservoir 22 containing the pressurized fluid mixture and the inlet section 13 of the discharge gap 36.

As already mentioned afore, the switching means 10, which are provided to be actuatable by the user on the outer casing 8 of the apparatus, are adapted to switch the valve means 24 on and off, i.e. into opening and closing, as needed.

In particular, with the same switching means it is possible for the high-voltage electrode 33 to be energized and, at the same time, the valve means 24 to be operated into opening.

Preferably, the valve means 24 are housed in the station 37 and may for instance be comprised of an electromagnetic valve powered from the power supply 15 and connected to the switching means 10.

In an alternative embodiment, the fluid supplying means comprise a fan, or impeller, provided in the station 37 and adapted to force an air stream to flow along the delivery conduit 38 and, as a result, through the inlet section 13 of del dielectric-barrier discharge assembly 2.

It has been experimentally found that a voltage situated within the range from 2.5 to 3.0 kV used to supply the high-voltage electrode 3, 33 will ensure the lowest formation of ozone in the plasma, so as to prevent the risk of dangerous ozone concentrations forming during the operation of the device.
Further, a low concentration of ozone avoids the degradation of plastics and rubbers.

Conclusively, it can therefore be stated that the fabric cleaning apparatus according to the present invention ensures an effective removal of organic-soil stains in an extremely simple and convenient manner, thereby doing away with the serious drawbacks shared by prior-art devices.

## Claims

1. Fabric cleaning apparatus comprising at least a dielectric-barrier discharge assembly (2) adapted to generate plasma at atmospheric pressure for decomposing and removing organic-soil stains from fabrics, said dielectric-barrier discharge assembly including a high-voltage electrode (3,33), a counter-electrode (4,34), and at least a dielectric barrier (5,35) to define a discharge gap (6,36) between said electrodes, and further comprising a high-voltage AC generator (7) connected to said high-voltage electrode (3,33), and fluid supplying means to supply said discharge gap with a flow of fluid medium, **characterized in that** it comprises an electrically insulating outer casing (8) accommodating said dielectric-barrier discharge assembly (2) and provided with an outlet nozzle (9) that is fluidly connected to said discharge gap (6,36), said outer casing (8) being adapted to be seized and hand-held by a user to position said outlet nozzle (9) in proximity to an organic-soil stain (11) to be removed from a fabric (12), switching means (10) being provided on said handheld outer casing (8) to switch on and off said high-voltage AC generator (7) and operate said fluid supplying means, accordingly.

2. Apparatus according to claim 1, wherein said fluid supplying means comprise at least a fan or impeller (19) adapted to force a stream of medium to flow through said discharge gap (6, 36), or a reservoir (22) fluidly connected to the discharge gap (6, 36) and containing a compressed medium, and valve means (24) to control and adjust the flow of said compressed medium through said discharge gap (6, 36).

3. Apparatus according to claim 2, wherein said switching means (10) are adapted to switch said fan (19) on and off, or to operate said valve means (24) into opening and closing.

4. Apparatus according to claim 3, wherein said fan (19) or said valve means (24) are provided inside said outer casing (8).

5. Apparatus according to claim 3 or 4, wherein said switching means (10) are adapted to energize the high-voltage electrode (3, 33) and, at the same time, switch on the fan (19) or operate said valve means (24) into opening, and are adapted to de-energize the high-voltage electrode (3, 33) and, at the same time, switch off the fan (19) or operate said valve means (24) into closing.

6. Apparatus according to claim 3 or 5, wherein said switching means (10) comprise a push-button capable of being actuated on the outer casing (8).

7. Apparatus according to any of the preceding claims, wherein said dielectric barrier (5) covers a surface of the high-voltage electrode (3) situated at an outlet section (14) of the discharge gap (6) and facing the outlet nozzle (9) of the outer casing (8) so as to form an auxiliary discharge gap (20) with an auxiliary ground electrode (21) provided externally relative to the outer casing (3) and adapted to support the stained fabric in a position close to the outlet nozzle (9).

8. Apparatus according to any of the preceding claims, wherein said fluid supplying means comprise a fluid-carrying conduit (16) provided inside the outer casing (8) to convey said flow of aeriform medium towards an inlet section (13) of the discharge gap (6).

9. Apparatus according to claim 8, wherein said fan (19) is adapted to take in air from the ambient outside the outer casing (8) through an inlet port (17) of the fluid-carrying conduit (16) and to convey said air towards an outlet port (18) of said fluid-carrying conduit (16) that is fluidly connected to the inlet section (13) of the discharge gap (6).

10. Apparatus according to claim 8, wherein said fluid-carrying conduit (16) is fluidly connected to said reservoir (22).

11. Apparatus according to any of the preceding claims, wherein the high-voltage AC generator (7) is provided inside the outer casing (8).

12. Apparatus according to claim 11, wherein the high-voltage AC generator (7) is connected to a storage battery provided inside the outer casing (8).

13. Apparatus according to claim 12, wherein said storage battery is adapted to energize the fan (19) or said valve means (24).

14. Apparatus according to any of the preceding claims 1-3, 5 when depending on claims 3, 6, wherein the dielectric-barrier discharge assembly (2) comprises a dielectric barrier (35) that surrounds a counter-electrode (34) without establishing any contact therewith, said counter-electrode (34) being arranged within said dielectric barrier (35), and comprises a high-voltage electrode (33) in the form of a wire that is spirally wound round the outer surface of the dielectric barrier (35) in contact therewith, a discharge gap (36) being created between said counter-electrode (34) and said dielectric barrier (35).

15. Apparatus according to claim 14, wherein the high-voltage AC generator (7) and the fluid supplying means are provided outside the outer casing (8).

16. Apparatus according to claim 15, wherein a delivery conduit (38) is provided to fluidly connect the fluid supplying means to the discharge gap (36).

17. Apparatus according to any of the preceding claims, wherein said high-voltage electrode (3, 33) is supplied with a power-supply voltage having a value situated anywhere between 2.5 and 3.0 kV so as to ensure a lowest possible ozone formation in the plasma.

## Patentansprüche

1. Textilstoffreinigungsvorrichtung, die mindestens eine Barrierenentladungs-Baugruppe (2) umfasst, welche geeignet ist, Plasma mit atmosphärischem Druck zum Auflösen und Entfernen organischer Schmutzflecken von Textilstoffen zu erzeugen, wobei die Barrierenentladungs-Baugruppe eine Hochspannungselektrode (3, 33), eine Gegenelektrode (4, 34) und mindestens eine dielektrische Barriere (5, 35) zur Ausbildung eines Entladungsspalts (6, 36) zwischen den Elektroden umfasst, ferner umfassend einen Hochspannungs-Wechselstromgenerator (7), der mit der Hochspannungselektrode (3, 33) verbunden ist, und ein Fluidzuführungsmittel zur Zuführung eines Fluidmediumstroms zu dem Entladungsspalt, **dadurch gekennzeichnet, dass** sie ein elektrisch isolierendes Außengehäuse (8) umfasst, in dem die Barrierenentladungs-Baugruppe (2) untergebracht ist, und mit einer Auslassdüse (9) ausgestattet ist, die in Fluidverbindung mit dem Entladungsspalt (6, 36) ist, wobei das Außengehäuse (8) dazu ausgeführt ist, von einem Benutzer ergriffen und in der Hand gehalten zu werden, um die Auslassdüse (9) in die Nähe eines organischen Schmutzflecks (11) zu positionieren, der von einem Textilstoff (12) entfernt werden soll, wobei an dem in der Hand tragbaren Außengehäuse (8) ferner Schaltmittel (10) vorgesehen sind, um den Hochspannungs-Wechselstromgenerator (7) ein und aus zu schalten und das Fluidzuführungsmittel entsprechend zu betätigen.

2. Vorrichtung gemäß Anspruch 1, wobei das Fluidzuführungsmittel mindestens einen Ventilator oder Rotor (19), der geeignet ist, einen Mediumstrom zum Durchströmen des Entladungsspalts (6, 36) zu bringen, oder einen mit dem Entladungsspalt (6, 36) in Fluidverbindung stehenden und ein komprimiertes Medium enthaltenden Tank (22), und ferner ein Ventilmittel (24) zur Steuerung und Anpassung des Stroms des komprimierten Mediums durch den Entladungsspalt (6, 36) umfasst.

3. Vorrichtung gemäß Anspruch 2, wobei das Schaltmittel (10) geeignet ist, den Ventilator (19) ein und aus zu schalten oder das Ventilmittel (24) so zu betätigen, dass es sich schließt oder sich öffnet.

4. Vorrichtung gemäß Anspruch 3, wobei der Ventilator (19) oder das Ventilmittel (24) innerhalb des Außengehäuses (8) vorgesehen sind.

5. Vorrichtung gemäß Anspruch 3 oder 4, wobei das Schaltmittel (10) geeignet ist, die Hochspannungselektrode (3, 33) zu aktivieren und gleichzeitig den Ventilator (19) einzuschalten oder das Ventilmittel (24) zu öffnen, und ferner geeignet ist, die Hochspannungselektrode (3, 33) zu deaktivieren und gleichzeitig den Ventilator (19) auszuschalten oder das Ventilmittel (24) zu schließen.

6. Vorrichtung gemäß Anspruch 3 oder 5, wobei das Schaltmittel (10) einen Druckknopf umfasst, der am Außengehäuse (8) betätigt werden kann.

7. Vorrichtung gemäß einem der vorangehenden Ansprüche, wobei die dielektrische Barriere (5) eine Oberfläche der Hochspannungselektrode (3) bedeckt, die an einem Auslassabschnitt (14) des Entladungsspalts (6) angeordnet ist und der Auslassdüse (9) des Außengehäuses (8) zugewandt ist, um einen Zusatz-Entladungsspalt (20) mit einer Zusatz-Erdelektrode (21) bilden, die außerhalb des Außengehäuses (3) angeordnet und geeignet ist, den verschmutzten Textilstoff in einer Position nahe der Auslassdüse (9) zu halten.

8. Vorrichtung gemäß einem der vorangehenden Ansprüche, wobei das Fluidzuführungsmittel eine fluidführende Leitung (16) umfasst, die innerhalb des Außengehäuses (8) vorgesehen ist, um den Strom des luftförmigen Mediums zu einem Einlassabschnitt (13) des Entladungsspalts (6) zu befördern.

9. Vorrichtung gemäß Anspruch 8, wobei der Ventilator (19) geeignet ist, Luft von außerhalb des Außengehäuses (8) durch eine Einlassöffnung (17) der fluidführenden Leitung (16) aufzunehmen und diese Luft zu einer Auslassöffnung (18) der fluidführenden Leitung (16) zu befördern, die in Fluidverbindung mit dem Einlassabschnitt (13) des Entladungsspalts (6) steht.

10. Vorrichtung gemäß Anspruch 8, wobei die fluidführende Leitung (16) in Fluidverbindung mit dem Tank (22) steht.

11. Vorrichtung gemäß einem der vorangehenden Ansprüche, wobei der Hochspannungs-Wechselstromgenerator (7) innerhalb des Außengehäuses (8) vorgesehen ist.

12. Vorrichtung gemäß Anspruch 11, wobei der Hochspannungs-Wechselstromgenerator (7) an eine innerhalb des Außengehäuses (8) vorgesehene Speicherbatterie angeschlossen ist.

13. Vorrichtung gemäß Anspruch 12, wobei die Speicherbatterie geeignet ist, den Ventilator (19) oder das Ventilmittel (24) zu aktivieren.

14. Vorrichtung gemäß einem der Ansprüche 1-3, 5 in Abhängigkeit von den Ansprüchen 3, 6, wobei die Barrierenentladungs-Baugruppe (2) eine dielektrische Barriere (35) umfasst, die eine Gegenelektrode (34) umgibt, ohne mit dieser einen Kontakt herzustellen, wobei die Gegenelektrode (34) innerhalb der dielektrischen Barriere (35) angeordnet ist, und eine Hochspannungselektrode (33) in Form eines Drahtes umfasst, der spiralförmig um die Außenfläche der dielektrischen Barriere (35) in Kontakt mit dieser gewickelt ist, wobei zwischen der Gegenelektrode (34) und der dielektrischen Barriere (35) ein Entladungsspalt (36) geschaffen wird.

15. Vorrichtung gemäß Anspruch 14, wobei der Hochspannungs-Wechselstromgenerator (7) und das Fluidzuführungsmittel außerhalb des Außengehäuses (8) vorgesehen sind.

16. Vorrichtung gemäß Anspruch 15, wobei eine Zuführungsleitung (38) vorgesehen ist, um das Fluidzuführungsmittel in Fluidverbindung mit dem Entladungsspalt (36) zu versetzen.

17. Vorrichtung gemäß einem der vorangehenden Ansprüche, wobei die Hochspannungselektrode (3, 33) mit einer Energieversorgungsspannung versorgt wird, die einen Wert zwischen 2,5 und 3,0 kV aufweist, um eine möglichst geringe Ozonbildung im Plasma zu gewährleisten.

## Revendications

1. Appareil de nettoyage de tissu comprenant au moins un ensemble de décharge à barrière diélectrique (2) apte à produire un plasma à pression atmosphérique pour décomposer et retirer des taches de salissures organiques de tissus, ledit ensemble de décharge à barrière diélectrique comportant une électrode haute tension (3, 33), une contre-électrode (4, 34) et au moins une barrière diélectrique (5, 35) pour définir un entrefer de décharge (6, 36) entre lesdites électrodes, et comprenant en outre un générateur CA haute tension (7) connecté à ladite électrode haute tension (3, 33), et des moyens d'amenée de fluide pour introduire dans ledit entrefer de décharge un écoulement de milieu fluide, **caractérisé en ce qu'**il comprend un boîtier extérieur électriquement isolant (8) logeant ledit ensemble de décharge à barrière diélectrique (2) et muni d'une buse de sortie (9) qui est reliée fluidement audit entrefer de décharge (6, 36), ledit boîtier extérieur (8) étant conçu pour être pris et tenu à la main par un utilisateur afin de positionner ladite buse de sortie (9) à proximité d'une tache de salissure organique (11) à enlever d'un tissu (12), des moyens de commutation (10) étant réalisés sur ledit boîtier extérieur tenu à la main (8) pour la mise en et hors service dudit générateur CA haute tension (7) et pour le fonctionnement dudit moyen d'amenée de fluide, d'une manière correspondante.

2. Appareil selon la revendication 1, dans lequel lesdits moyens d'amenée de fluide comprennent au moins un ventilateur ou roue (19) apte à forcer un écoulement de milieu à travers ledit entrefer de décharge (6, 36), ou bien un réservoir (22) fluidement connecté à l'entrefer de décharge (6, 36) et contenant un milieu compressé, et des moyens de vanne (24) pour commander et ajuster l'écoulement dudit milieu compressé à travers ledit entrefer de décharge (6, 36).

3. Appareil selon la revendication 2, dans lequel lesdits moyens de commutation (10) sont aptes à commuter ledit ventilateur (19) en et hors service, ou pour actionner lesdits moyens de vanne (24) aux états d'ouverture et de fermeture.

4. Appareil selon la revendication 3, dans lequel ledit ventilateur (19) où lesdits moyens de vanne (24) sont prévus à l'intérieur dudit boîtier extérieur (8).

5. Appareil selon la revendication 3 ou 4, où lesdits moyens de commutation (10) sont conçus pour exciter l'électrode haute tension (3, 33) et, en même temps, commuter en service le ventilateur (19) ou actionner lesdits moyens de vanne (24) à l'état d'ouverture, et sont conçus pour désexciter l'électrode haute tension (3, 33) et, en même temps, commuter hors service le ventilateur (19) ou actionner lesdits moyens de vanne (24) à l'état de fermeture.

6. Appareil selon la revendication 3 ou 5, dans lequel lesdits moyens de commutation (10) comprennent un bouton-poussoir pouvant être actionné sur le boîtier extérieur (8).

7. Appareil selon l'une quelconque des revendications précédentes, dans lequel ladite barrière diélectrique (5) couvre une surface de l'électrode haute tension (3) située à une section de sortie (14) de l'entrefer de décharge (6) et orientée vers la buse de sortie (9) du boîtier extérieur (8) de manière à former un entrefer de décharge auxiliaire (20) avec une électrode auxiliaire (21) mise à la masse réalisée à l'extérieur relativement au boîtier extérieur (3) et apte à supporter l'étoffe tachée dans une position proche de la buse de sortie (9).

8. Appareil selon l'une quelconque des revendications précédentes, dans lequel lesdits moyens d'amenée de fluide comprennent une conduite porteuse de fluide (16) réalisée à l'intérieur du boîtier extérieur (8) pour convoyer ledit écoulement de milieu gazeux vers une section d'admission (13) de l'entrefer de décharge (6).

9. Appareil selon la revendication 8, dans lequel ledit ventilateur (19) est apte à aspirer l'air de l'air ambiant à l'extérieur du boîtier extérieur (8) à travers un orifice d'entrée (17) de la conduite porteuse de fluide (16) et à convoyer ledit air vers un orifice de sortie (18) de la conduite porteuse de fluide (16) qui est relié fluidement à la section d'admission (13) de l'entrefer de décharge (6).

10. Appareil selon la revendication 8, dans lequel ladite conduite porteuse de fluide (16) est reliée fluidement audit réservoir (22).

11. Appareil selon l'une quelconque des revendications précédentes, dans lequel le générateur CA haute tension (7) est réalisé à l'intérieur du boîtier extérieur (8).

12. Appareil selon la revendication 11, dans lequel le générateur CA haute tension (7) est relié à une batterie de stockage réalisée à l'intérieur du boîtier extérieur (8).

13. Appareil selon la revendication 12, dans lequel ladite batterie de stockage est apte à exciter le ventilateur (19) ou lesdits moyens de vanne (24).

14. Appareil selon l'une quelconque des revendications précédentes 1 à 3, 5 lorsqu'elles dépendent des revendications 3, 6, où l'ensemble de décharge à barrière diélectrique (2) comprend une barrière diélectrique (35) qui entoure une contre-électrode (34) sans établir de contact avec celle-ci, ladite contre-électrode (34) étant agencée dans ladite barrière diélectrique (35) et comprend une électrode haute tension (33) sous la forme d'un fil qui est enroulé en spirale autour de la surface externe de la barrière diélectrique (35) en contact avec celle-ci, un entrefer de décharge (36) étant créé entre ladite contre-électrode (34) et ladite barrière diélectrique (35).

15. Appareil selon la revendication 14, dans lequel le générateur CA haute tension (7) et le moyen d'amenée de fluide sont réalisés à l'extérieur du boîtier extérieur (8).

16. Appareil selon la revendication 15, dans lequel une conduite de délivrance (38) est réalisée pour relier fluidement le moyen d'amenée de fluide à l'entrefer de décharge (36).

17. Appareil selon l'une quelconque des revendications précédentes, dans lequel ladite électrode haute tension (3, 33) est munie d'une tension d'amenée de puissance d'une valeur située n'importe où entre 2,5 et 3,0 kV de manière à assurer une formation d'ozone la plus basse possible dans le plasma.
